# EUROPEAN PATENT SPECIFICATION

(11) **EP 0 635 934 B1**
(45) Date of publication and mention of the grant of the patent: **09.09.1998**
(21) Application number: 94117670.3
(22) Date of filing: 06.02.1991
(51) Int. Cl.: H03F 3/60

(54) **Constant-amplitude wave combination type amplifier**
Verstärker für kombinierte Wellen mit konstanter Amplitude
Amplificateur pour ondes d'amplitude constante combinée

(30) Priority: 07.02.1990 JP 27698/90; 07.02.1990 JP 27699/90; 07.02.1990 JP 27700/90
(43) Date of publication of application: 25.01.1995
(62) Divisional of application: 91101602.0
(73) Proprietor: FUJITSU LIMITED, Kawasaki-shi, Kanagawa 211 (JP)
(72) Inventor: Okubo, Naofumi, Kawasaki-shi, Kanagawa, 212 (JP); Asano, Yoshihiko, Ohta-ku, Tokyo, 146 (JP); Kurihara, Hiroshi, Suginami-ku, Tokyo, 166 (JP); Daido, Yoshimasa, Yokohama-shi, Kanagawa, 241 (JP); Kobayashi, Kazuhiko, Kawasaki-shi, Kanagawa, 214 (JP); Kobayakawa, Shuji, Yokohama-shi, Kanagawa, 240 (JP); Maniwa, Toru, Kawasaki-shi, Kanagawa, 211 (JP)
(74) Representative: Lehn, Werner, Dipl.-Ing.

(56) References cited:
- GB-A- 2 073 516
- GB-A- 2 207 582
- US-A- 4 554 514

## Description

### BACKGROUND OF THE INVENTION

The present invention generally relates to a constant-amplitude wave combination type amplifier, and more particularly to a constant-amplitude wave combination type amplifier based on a LINC (linear amplification with non-linear components) process.

US-A-3 909 742 discloses an amplifier for linearly amplifying a bandpass high frequency analog input signal by a plurality of amplifying means including those having a non-linear characteristic. These amplifying means include first combining means for producing from the input signal first and second signal components having constant amplitude but differing in phase, first and second non-linear amplifiers for separately amplifying said first and second component signals, second combining means for recombining the amplified first and second component signals output by said first and second amplifiers, respectively, so as to generate an output signal formed by the difference of said first and second amplified component signals and being a linearly amplified replica of the input signal, and to also generate a feedback signal being the sum of said first and second amplified component signals and fed to said first combining means for combining the input and feedback signal.

Moreover, constant-amplitude wave combination type amplifiers have been widely used in various communication devices, such as radio devices for use in mobile communications, multiple radio devices, satellite communication radio devices, and broadcasting devices. There is a need to realize such constant-amplitude wave combination amplifiers which consume a small amount of power and which are configured of a small number of structural elements.

Constant-amplitude wave combination type amplifiers based on the LINC process are known as amplifiers which meet the above-mentioned need, and are disclosed in, for example, D.C. Cox, "Linear Amplification with Non-linear Components", IEEE Transactions on Communications, December 1974, pp. 1942-1945. An application of constant-amplitude wave combination type amplifiers based on the LINC process is proposed in Japanese Laid-Open Patent Application No. 1-284106.

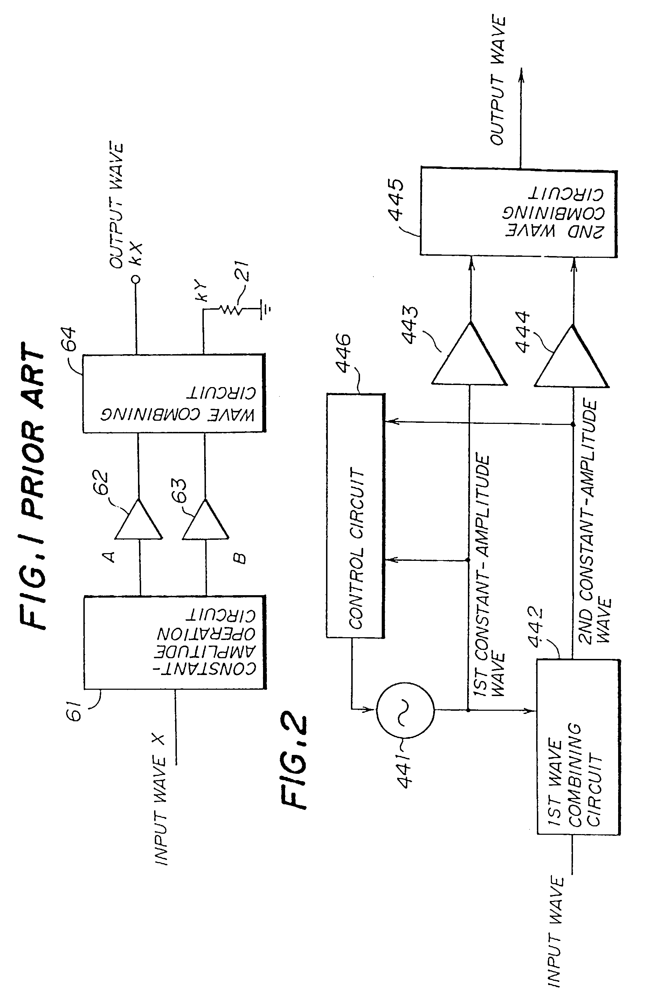

FIG.1 shows a conventional constant-amplitude wave combination type amplifier. As shown, the amplifier has a constant-amplitude wave operation circuit 61, two amplifiers 62 and 63, and a wave combining circuit 64. The constant-amplitude wave operation circuit 61 is formed of a digital signal processing circuit, and calculates an orthogonal wave Y orthogonal to an input wave X so that each combined wave obtained by combining the waves X and Y with each other has a constant amplitude. Then, the constant-amplitude wave operation circuit 61 outputs constant-amplitude waves A and B which have constant envelopes having equal amplitudes by the above-mentioned combination of the waves X and Y. Capital letters X, Y, A and B are vector amounts which include phases.

The amplifiers 62 and 63, which are formed of non-linear amplifiers such as C-class amplifiers, amplify the constant-amplitude waves A and B, respectively. The wave combining circuit 64 combines constant amplitude waves kA and kB respectively output by the amplifiers 62 and 63, and generates an output wave kX which is an amplified version of the input wave X.

The conventional configuration shown in FIG.1 has an advantage in that the amplifiers 62 and 63 are not required to be formed of linear amplifiers, since it is sufficient to amplify the constant-amplitude waves A and B of the constant envelopes. In addition, since the original signal can be reproduced by the wave combining circuit 64, it is possible to linearly amplify the input wave X having little distortion irrespective of the use of the non-linear amplifiers.

As has been described previously, the constant-amplitude wave operation circuit 61 is formed of a digital signal processing circuit. However, the digital signal processing circuit consumes a large amount of power and is not suitable for high-speed signal processing. Further, the use of the digital signal processing circuit causes an increase in the size of the amplifier. For the above reasons, the use of conventional constant-amplitude wave combination type amplifiers is limited to special applications in which the amount of power consumed in the digital signal processing circuit or the size of the amplifier are negligible, or applications in which data is transferred at a low speed.

### SUMMARY OF THE INVENTION

It is a general object of the present invention to provide an improved constant-amplitude wave combination type amplifier in which the above-mentioned disadvantages are eliminated.

A more specific object of the present invention is to provide a constant-amplitude wave combination type amplifier which consumes a small amount of power, is formed of a small number of structural elements and operates at a high speed.

According to the present invention, the above-mentioned objects are achieved by a constant-amplitude wave combination type amplifier as specified in claim 1.

Further improvements according to the present invention are specified in claims 2 to 9 being dependent on claim 1.

### BRIEF DESCRIPTION OF THE DRAWINGS

The objects, features and advantages of the present invention will become more apparent from the following detailed description when read in conjuncton with the accompanied drawings showing in
Fig. 1 a block diagram of a conventional constant-amplitude wave combination type amplifier;
Fig. 2 is a block diagram illustrating an outline of a constant-amplitude wave combination type amplifier according to a twelfth preferred embodiment of the present invention;
FIG.3 is a block diagram illustrating the configuration shown in FIG.2 in more detail;
FIGS.4, 5 and 6 are respectively graphs illustrating the operation of the configuration shown in FIG. 3;
FIG.7 is a block diagram illustrating a variation of the configuration shown in FIG.3;
FIG.8 is a block diagram illustrating an outline of a constant-amplitude wave combination type amplifier shown for better understanding of the present invention;
FIG.9 is a block diagram illustrating the configuration shown in FIG.8 in more detail;
FIG.10 is a block diagram illustrating a variation of the configuration shown in FIG.9;
FIG.11 is a block diagram illustrating an outline of a constant-amplitude wave combination type amplifier according to a further preferred embodiment of the present invention;
FIG.12 is a block diagram illustrating the configuration shown in FIG.11 in more detail;
FIG.13 is a block diagram illustrating a first variation of the configuration shown in FIG.12;
FIG.14 is a block diagram illustrating an outline of a second variation of the configuration shown in FIG.12; and
FIG.15 is a block diagram illustrating the configuration of the second variation shown in FIG.14 in more detail.

### DESCRIPTION OF THE PREFERRED EMBODIMENTS

A description will now be given of a constant-amplitude wave combination type amplifier according to a first embodiment of the present invention with reference to FIG.2. The amplifier shown in FIG.2 has first and second wave combining circuits 442 and 445, two amplifiers 443 and 444, a variable frequency generator 41 and a control circuit 446. The variable frequency generator 441 generates a first constant-amplitude wave, and the first wave combining circuit 442 generates a second constant-amplitude wave. The amplifiers 443 and 444 amplify the first and second constant-amplitude waves, respectively, and output amplified waves to the second wave combining circuit 445. The control circuit 446 calculates the difference between the first and second constant-amplitude waves, and controls the variable frequency generator 441 on the basis of the calculation result so that the above-mentioned difference becomes zero. With the above arrangement, it is possible to generate the constant-amplitude waves which have constant envelope amplitudes. Thus, the amplifiers 443 and 444 can be formed of analog non-linear amplifiers, and the output wave has little distortion.

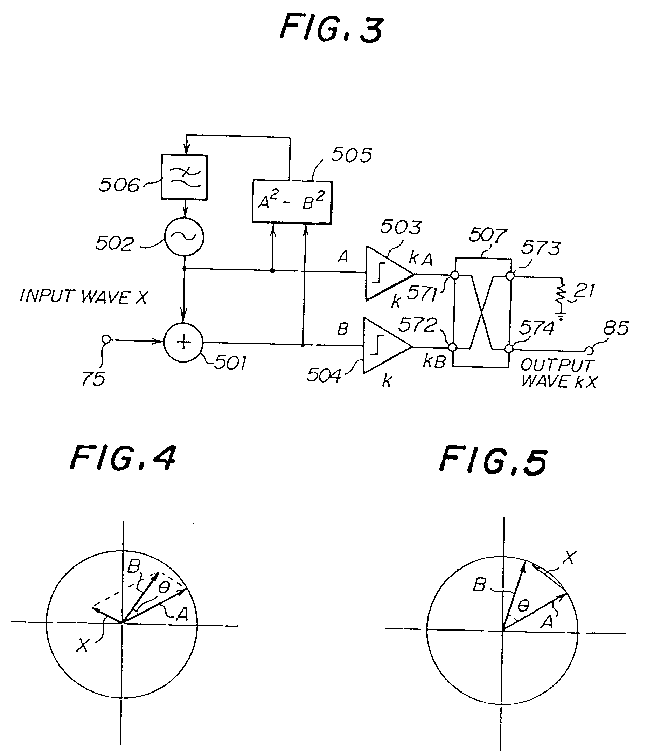

FIG.3 shows the configuration shown in FIG.2 in more detail. The input wave X is applied to an adder 501 via the input terminal 75. The adder 501 adds an input wave X and a constant-amplitude wave A generated by a voltage-controlled oscillator 502, which generates a constant-amplitude wave B therefrom. The constant-amplitude waves A and B are supplied to an operation circuit 505, which carries out an operation A² - B². The operation result indicates a value corresponding to the difference between the amplitudes of the constant-amplitude waves A and B, and is supplied to the voltage-controlled oscillator 502 via a lowpass filter 506. The lowpass filter 506 extracts a D.C. component from the output of the operation circuit 505. The D.C. component is supplied to the voltage-controlled oscillator 502 as a control signal (voltage) which corrects a phase error.

The constant-amplitude waves A and B are amplified by amplifiers 503 and 504, respectively, each having an amplification gain k. The amplifiers 503 and 504 can be formed of linear amplifiers, such as C-class amplifiers. Amplified outputs kA and kB output by the amplifiers 503 and 504 are applied to input terminals 571 and 572, respectively, of a 180°-out-of-phase hybrid circuit 507. The hybrid circuit 507 branches each of the amplified waves kA and kB into two waves. Then, the hybrid circuit 507 outputs in-phase components to identical direction output terminals (output terminals 573 and 574 with respect to the input terminals 571 and 572, respectively), and outputs 180°-out-of-phase components to cross-direction output terminals (output terminals 574 and 573 with respect to the input terminals 571 and 572, respectively). An output wave kX, which is an amplified version of the input wave X, is obtained at the output terminal 574 of the hybrid circuit 507. The output terminal 574 is terminated via the terminating resistor 21.

The operation of the amplifier shown in FIG.3 will now be explained. The input wave X is added to the constant-amplitude wave A from the voltage-controlled oscillator 502 on the vector base, so that the constant-amplitude wave B is output by the adder 501. If no phase shift control is carried out, the waves A, B and X will have a relationship shown in FIG.4. The amplitude of the constant-amplitude wave A is different from that of the combined wave B. Further, the amplitude of the combined wave B varies in accordance with a change of the amplitude of the constant-amplitude wave A. Thus, the combined wave B does not have a constant amplitude.

The operation circuit 505 carries out the operation A² - B², and the oscillating frequency (or phase) of the voltage-controlled oscillator 502 is controlled so that A² - B² = 0. That is, a phase angle Δθ between the waves A and B is adjusted so that the amplitudes of the waves A and B are equal to each other. In the state where A² - B² = 0, the amplifier shown in FIG.3 can operate stably. That is, as shown in FIG.5, the vector loci of the waves A and B are on a circle, so that the combined wave B can have a constant amplitude. As a result, the amplifiers 503 and 504 can be formed of analog non-linear amplifiers, such as C-class amplifiers.

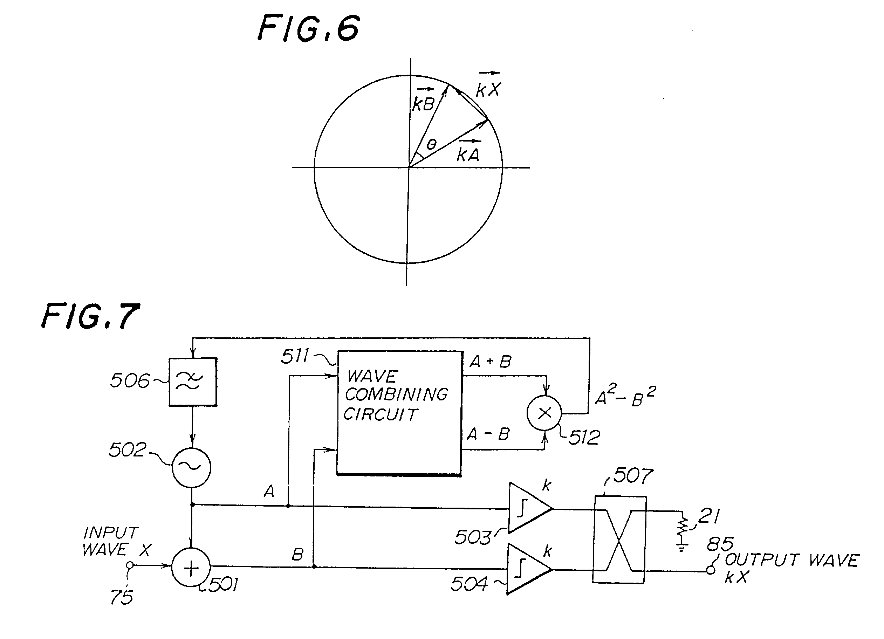

The amplified outputs kA and kB are input to the hybrid circuit 507, and combined therein. FIG.6 illustrates a phase relationship between the amplified outputs kA and kB. An output wave k(B - A) appears at the output terminal 574, which is an amplified version of the input wave X. That is, kX = k(B - A).

FIG.7 illustrates a variation shown in FIG.2. In FIG.7, those parts which are the same as those shown in FIG.3 are given the same reference numerals. The operation circuit 505 shown in FIG.3 is replaced by a wave combining circuit 511 and a multiplier 512. The wave combining circuit 511 combines the constant-amplitude waves A and B and generates two composite waves A + B and A - B. The multiplier 512 multiplies the wave A + B by the wave A - B, and outputs A² - B², which passes through the lowpass filter 506, and is applied to the voltage-controlled oscillator 502.

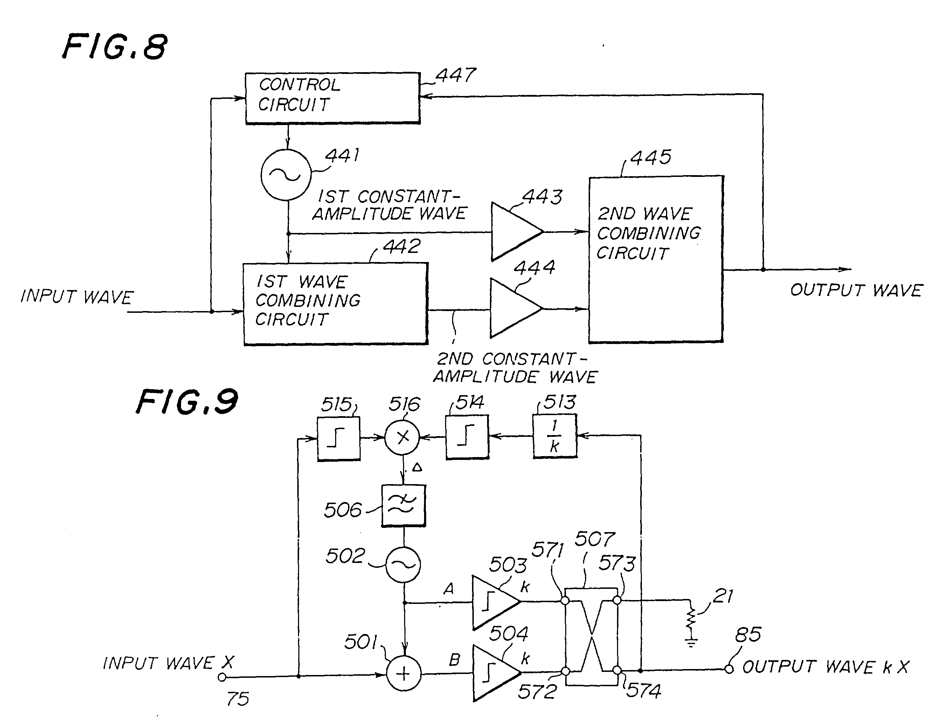

A description will now be given of a constant-amplitude wave combination circuit described for better understanding of the present invention with reference to FIG.8, in which those parts which are the same as those shown in FIG.2 are given the same reference numerals. A control circuit 447 is substituted for the control circuit 446 shown in FIG.2. The control circuit 447 extracts a distortion component contained in the output wave, and controls the gain of the variable frequency generator 441 so that the extracted distortion component is reduced. When the distortion component is sufficiently reduced, the first and second constant-amplitude waves generated respectively by the variable frequency generator 441 and the first wave combining circuit 442 have constant envelope amplitudes.

FIG.9 illustrates the configuration shown in FIG.8 in more detail. In FIG.9, those parts which are the same as those shown in FIG.3 are given the same reference numerals. The control circuit 447 shown in FIG.8 is made up of an attenuator 513 having an attenuation level 1/k, two limiter amplifiers 514 and 515, a multiplier 516 and a lowpass filter 506. The output wave kX generated by the 180°-out-of-phase hybrid circuit 507 passes through the attenuator 513 and the limiter amplifier 514, and is applied to the multiplier 516. On the other hand, the input wave X passes through the limiter amplifier 515 and is applied to the multiplier 516. The multiplier 516 multiplies the output from the limiter amplifier 514 by the output from the limiter amplifier 515, and generates a distortion component Δ contained in the output wave kX. The distortion component passes through the lowpass filter 506, and is applied, as the frequency (phase) control voltage, to the voltage-controlled oscillator 502.

If the combined wave B from the adder 501 is not a constant-amplitude wave, the amplified output kB will be distorted since the amplifier 504 is formed of a non-linear amplifier. Thus, the output wave kX will contain a distortion component. It can be seen from the above that if the combined wave B is a constant-amplitude wave, it is possible to minimize the distortion component contained in the output wave kX generated by the 180°-out-of-phase hybrid circuit 507.

The distortion component in the output wave kX is extracted by means of the attenuator 513, the limiter amplifiers 514 and 515 and the multiplier 516, and applied, as the frequency (or phase) control voltage, to the voltage-controlled oscillator 502. With the above control, the distortion component in the output wave kX is reduced, so that the combined wave B becomes a constant-amplitude wave.

It will be noted that the use of the limiter amplifier 515 is directed to maintaining the input signal at a certain level so that the circuit operation operates in the unstable state when the input wave X becomes small. The limiter amplifier 515 is provided for adjusting the phase relationship between the feedback loop carrying the output wave kX and the feedback loop carrying the input wave X.

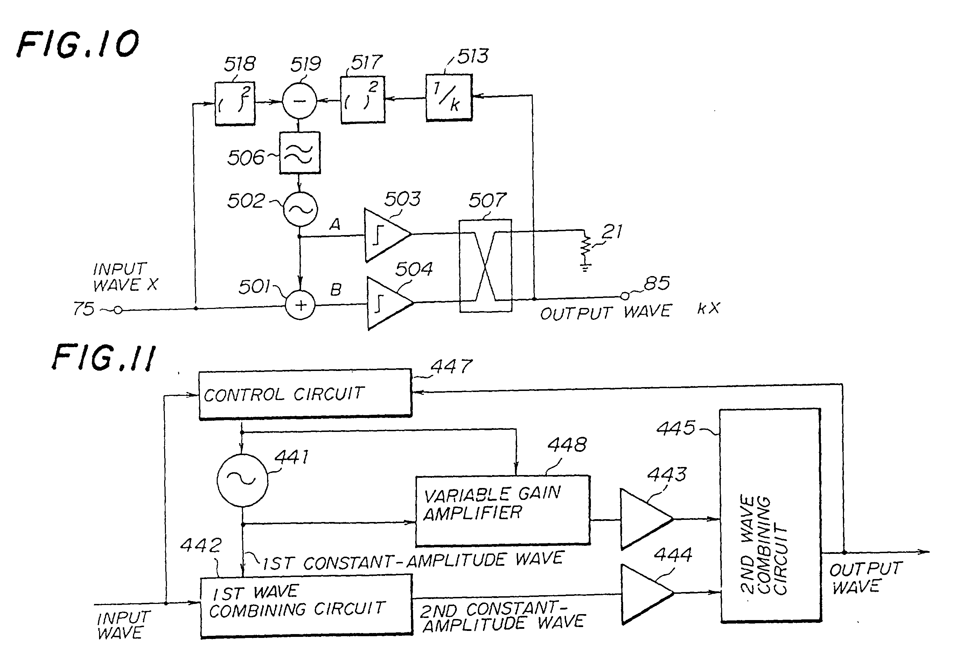

FIG.10 illustrates a variation of the configuration shown in FIG.9. In FIG.10, those parts which are the same as those shown in FIG.9 are given the same reference numerals. Square-law circuits 517 and 518 are respectively substituted for the limiter amplifiers 514 and 515 shown in FIG.9, and a subtracter 519 is substituted for the multiplier 516 shown in FIG.9. The subtracter 519 outputs the distortion component contained in the output wave kX by calculating the difference between the output wave kX passing through the attenuator 513 and the square-law circuit 517 and the input wave X from the square-law circuit 518.

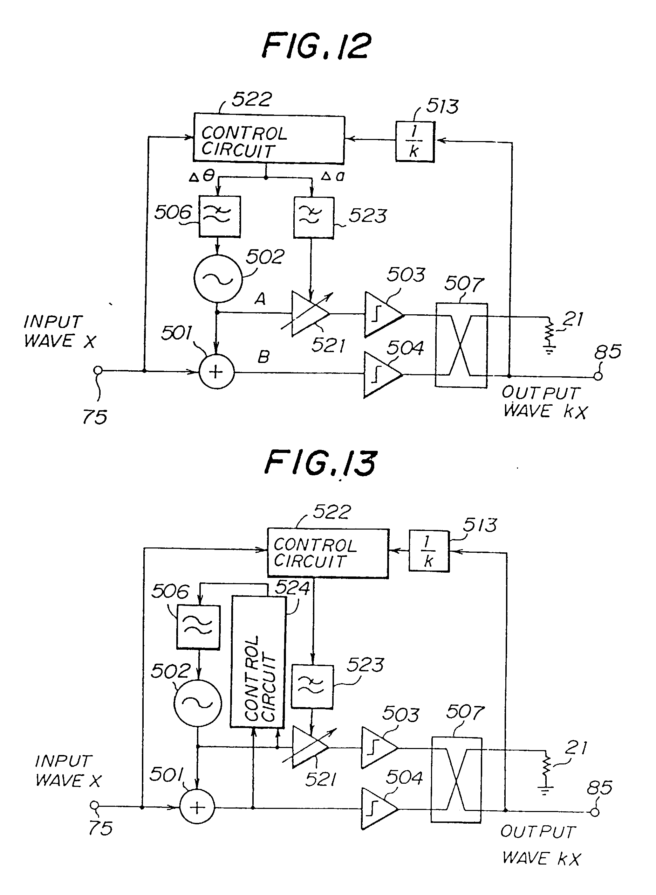

FIG.11 shows a constant-amplitude wave combination type amplifier according to an embodiment for better understanding of the present invention. In FIG.11, those parts which are the same as those shown in FIG.8 are given the same reference numerals. A variable gain amplifier 448 is provided between the output terminal of the variable frequency generator 441 and the amplifier 443. The variable gain amplifier 448 is controlled by the output signal of the control circuit 447 (distortion component) so that an amplitude error occurring between the constant-amplitude waves can be eliminated.

FIG.12 illustrates the configuration shown in FIG.11 in more detail. In FIG.12, those parts which are the same as those shown in FIG.9 are given the same reference numerals. The distortion component (Δθ) extracted from the output wave kX by a control circuit functions as the control voltage applied to the voltage-controlled oscillator 502 but also as a control voltage Δa applied to an AGC amplifier 521 through a lowpass filter 523. It will be noted that the control circuit 522 corresponds to the combination of the limiter amplifiers 514, 515 and the multiplier 516 shown in FIG.9, or the combination of the square-law circuits 517, 518 and the subtracter 519 shown in FIG.10.

In the configuration shown in FIG.9 or FIG.10, there is a possibility that the phase adjustment by the voltage-controlled osciliator 502 will not completely cancel an amplitude error occurring between the constant-amplitude waves A and B, although the phase error can be eliminated completely by the voltage-controlled oscillator 502. In this case, the output wave kX contains a distortion component. The configuration shown in FIG.12 is directed to eliminating such a distortion component. The distortion component extracted by the control circuit 522 is used for controlling not only the oscillation frequency of the voltage-controlled oscillator 502 but also the gain of the AGC amplifier 521 (amplitude of the constant-amplitude wave) so that the extracted distortion component is canceled. In this way, the configuration shown in FIG.12 adjusts the phase and amplitude. It will be noted that the AGC amplifier 521 can be provided between the adder 501 and the limiter amplifier 504.

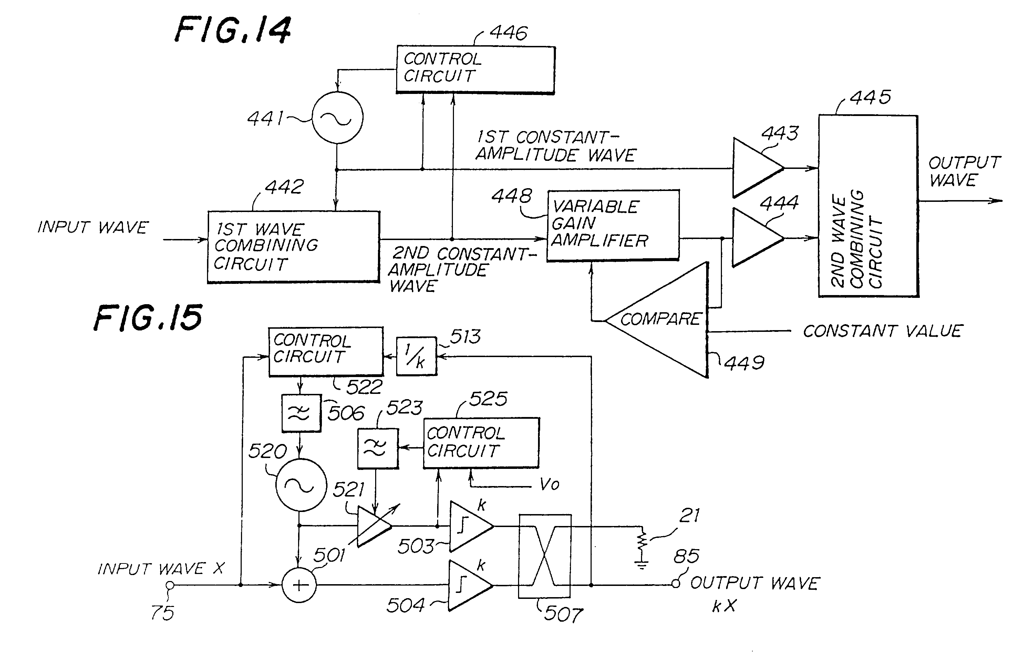

FIG.13 illustrates a further embodiment of the present invention, which embodiment is a first variation based on the principle of the configuration shown in FIG.11. In FIG.13, those parts which are the same as those shown in FIG.12 are given the same reference numerals. The voltage-controlled oscillator 502 is controlled by a control circuit 524 provided separately from the control circuit 522. The control circuit 524 can be formed of, for example, the operation circuit 505 shown in FIG.3. The control voltage applied to the voltage-controlled oscillator 502 is generated from the amplitude difference obtained by calculating A² - B² by the control circuit 524. On the other hand, the control voltage applied to the AGC amplifier 521 is generated from the distortion component contained in the output wave kX by the control circuit 522.

FIG.14 illustrates an outline of a further embodiment of the present invention, being second variation based on the principle of the configuration shown in FIG.11. In FIG.14, those parts which are the same as those shown in the previous figures are given the same reference numerals. The variable gain amplifier 448 is controlled by a comparator circuit 449, which compares the output signal of the variable gain amplifier 448 with a constant value.

FIG.15 illustrates the configuration shown in FIG.14 in more detail. In FIG.15, those parts which are the same as those shown in FIG.12 are given the same reference numerals. A control circuit 525 corresponds to the comparator circuit 449 shown in FIG.14. That is, the control circuit 525 is made up of two square-law circuits 338 and 340, the l/k attenuator 327 and the subtracter 339. When the AGC amplifier 521 operates normally, the output thereof has a constant amplitude. This constant amplitude is determined to be a reference value Vo. The control circuit 525 controls the gain of the AGC amplifier 521 via the lowpass filter 521 so that the output of the AGC amplifier 521 is equal to the reference value Vo. With the above arrangement, cancel an amplitude error can be cancelled.

The present invention is not limited to the specifically disclosed embodiments, but only by the scope of the appended claims.

Reference signs in the claims are intended for better understanding and shall not limit the scope.

## Claims

1. A constant-amplitude wave combination type amplifier, comprising
variable-frequency wave generating means (441, 502) for generating a first constant-amplitude wave (A) having a frequency controllable by a control signal;
first wave combining means (442, 501) coupled to said variable-frequency wave generating means, for generating a second constant-amplitude wave (B) by combining an input wave (X) and said first constant-amplitude wave (A);
a first amplifier (443, 503) amplifying said first constant-amplitude wave and generating a first amplified output (kA);
a second amplifier (444, 504) amplifying said second constant-amplitude wave and generating a second amplified output (kB);
second wave combining means (445, 507) coupled to said first and second amplifiers, for combining said first and second amplified outputs and for generating an output wave (kX); and
control means (446, 505; 511, 512; 524) coupled to said variable-frequency generating means and to said first combining means, and provided for calculating a term (A² - B²) where A is an amplitude of said first constant-amplitude wave received from said variable-frequency generating means, and B is an amplitude of said second constant-amplitude wave received from said first combining means, and outputting an output according to said calculated term, for generating said control signal.

2. The constant-amplitude wave combination type amplifier as claimed in claim 1, wherein a first filter (506) is provided between said control means and said variable-frequency wave generating means, which filter extracts a D.C. component from said output of said control means for suppling said D.C. component to said variable-frequency wave generating means as a control signal.

3. The constant-amplitude wave combination type amplifier as claimed in claim 2, wherein said variable-frequency wave generating means comprises a voltage-controlled oscillator (502) controlled by said D.C. component.

4. The constant-amplitude wave combination type amplifier as claimed in any of claims 1 to 3, wherein said control means comprises operation means (505) for calculating said term (A² - B²) and generating an output according to said term.

5. The constant-amplitude wave combination type amplifier as claimed in any of claims 1 to 3, wherein said control means comprises
operation means (511) for calculating terms (A + B) and (A - B) from the amplitudes of said first and second constant-amplitude waves, and
multiplying means (512) for multiplying (A + B) and (A - B) so as to obtain the term (A² - B₂), and for generating an output according to said term.

6. The constant-amplitude wave combination type amplifier as claimed in any of claims 1 to 5, comprising
variable gain amplifier means (521) for amplifying one of said first and second constant-amplitude waves by a gain and for outputting an amplified wave to one of said first and second amplifiers; and
further control means (522) for generating a correction value indicatave of a distortion component contained in said output wave, by comparing said input wave with said output wave, and for controlling the gain of said variable gain amplifier means on the basis of said correction value so that said distortion component contained in said output wave is reduced.

7. The constant-amplitude wave combination type amplifier as claimed in claim 6, wherein a second filter (523) is provided for extracting a second D.C. component from the output of said further control means (522) for suppling it to said variable gain amplifier means.

8. The constant-amplitude wave combination type amplifier as claimed in claim 7, wherein said variable gain amplifier means comprises an automatic -gain control amplifier (521) controlled by said second D.C. component.

9. The constant-amplitude wave combination type amplifier as claimed in any of claims 1 to 5, comprising
variable gain amplifier means (448) for amplifying one of said first and second constant-amplitude waves by a gain and for outputting an amplified wave to one of said first and second amplifiers; and
further control means (449) for generating a correction value indicatave of a distortion component contained in said output wave, by comparing one of said amplified outputs with a predetermined constant value (Vo) and for contreolling said gain of said variabe gain amplifier means on the basis of said correction value so that said distortion component contained in said output wave is reduced.

## Patentansprüche

1. Konstantamplitudenwellen-Verstärker vom Kombinationstyp, umfassend:
eine Wellenerzeugungseinrichtung mit veränderlicher Frequenz (441, 502) zur Erzeugung einer ersten Welle (A) mit konstanter Amplitude mit einer Frequenz, die mittels eines Steuersignals einstellbar ist;
eine erste Wellenkombinationseinrichtung (442, 501), die mit der Wellenerzeugungseinrichtung mit veränderlicher Frequenz verbunden ist, zur Erzeugung einer zweiten Welle (B) mit konstanter Amplitude mittels Kombination einer Eingangswelle (X) und der ersten Welle (A) mit konstanter Amplitude;
einen ersten Verstärker (443, 503) zur Verstärkung der ersten Welle mit konstanter Amplitude und zur Erzeugung einer ersten verstärkten Ausgabe (kA);
einen zweiten Verstärker (444, 504) zur Verstärkung der zweiten Welle mit konstanter Amplitude und zur Erzeugung einer zweiten verstärkten Ausgabe (kB);
eine zweite Wellenkombinationseinrichtung (445, 507), die mit dem ersten und zweiten Verstärker verbunden ist, um die erste und zweite verstärkte Ausgabe zu kombinieren und zur Erzeugung einer Ausgangswelle (kX); und
eine Steuereinrichtung (446, 505; 511, 512; 524), die mit der Erzeugungseinrichtung mit veränderlicher Frequenz und der ersten Kombinationseinrichtung verbunden ist, und zur Berechnung eines Ausdrucks (A² - B²) zur Verfügung gestellt ist, wobei A eine Amplitude der ersten Welle mit konstanter Amplitude ist, die von der Erzeugungseinrichtung mit veränderlicher Frequenz empfangen wird, und B eine Amplitude der zweiten Welle mit konstanter Amplitude ist, die von der ersten Kombinationseinrichtung empfangen wird, und zur Ausgabe einer Ausgabe gemäß dem berechneten Ausdruck zur Erzeugung des Steuersignals.

2. Konstantamplitudenwellen-Verstärker vom Kombinationstyp nach Anspruch 1, **dadurch gekennzeichnet**, daß ein erster Filter (506) zwischen der Steuereinrichtung und der Wellenerzeugungseinrichtung mit veränderlicher Frequenz angeordnet ist, der eine Gleichkomponente aus der Ausgabe der Steuereinrichtung herauszieht zum Anlegen der Gleichkomponente an die Wellenerzeugungseinrichtung mit veränderlicher Frequenz als ein Steuersignal.

3. Konstantamplitudenwellen-Verstärker vom Kombinationstyp nach Anspruch 2, **dadurch gekennzeichnet,** daß die Wellenerzeugungseinrichtung mit veränderlicher Frequenz einen spannungsgesteuerten Oszillator (502) umfaßt, der mittels der Gleichkomponente gesteuert wird.

4. Konstantamplitudenwellen-Verstärker vom Kombinationstyp nach einem der Ansprüche 1 bis 3, **dadurch gekennzeichnet,** daß die Steuereinrichtung eine Recheneinrichtung (505) umfaßt zur Berechnung des Ausdrucks (A² - B²) und zur Erzeugung einer Ausgabe gemäß dem Ausdruck.

5. Konstantamplitudenwellen-Verstärker vom Kombinationstyp nach einem der Ansprüche 1 bis 3, **dadurch gekennzeichnet,** daß die Steuereinrichtung eine Recheneinrichtung (511) umfaßt, um Ausdrücke (A + B) und (A - B) von den Amplituden der ersten und zweiten Welle mit konstanter Amplitude zu berechnen und eine Multiplizierereinrichtung (512), um (A + B) und (A - B) zu multiplizieren, um den Ausdruck (A² - B²) zu erhalten und zur Erzeugung einer Ausgabe gemäß dem Ausdruck.

6. Konstantamplitudenwellen-Verstärker vom Kombinationstyp nach einem der Ansprüche 1 bis 5, **gekennzeichnet durch**
eine Verstärkereinrichtung mit veränderlichem Verstärkungsfaktor (521) zur Verstärkung von einer der ersten und zweiten Amplitudenwellen mit konstanter Amplitude mit einem Verstärkungsfaktor und zur Ausgabe einer verstärkten Welle zu einem der ersten und zweiten Verstärker; und
eine weitere Steuereinrichtung (522) zur Erzeugung eines Korrekturwerts, der eine Verzerrungskomponente angibt, die in der Ausgangswelle enthalten ist, mittels Vergleich der Eingangswelle mit der Ausgangswelle, und zur Steuerung des Verstärkungsfaktors der Verstärkereinrichtung mit veränderlichem Verstärkungsfaktor, basierend auf dem Korrekturwert, so daß die Verzerrungskomponente, die in der Ausgangswelle enthalten ist, verringert wird.

7. Konstantamplitudenwellen-Verstärker vom Kombinationstyp nach Anspruch 6, **dadurch gekennzeichnet,** daß ein zweiter Filter (523) angeordnet ist, um eine zweite Gleichkomponente aus der Ausgabe von der Ausgabe der weiteren Steuereinrichtung (522) herauszuziehen, um diese der Verstärkereinrichtung mit veränderlichem Verstärkungsfaktor zuzuführen.

8. Konstantamplitudenwellen-Verstärker vom Kombinationstyp nach Anspruch 7, **dadurch gekennzeichnet,** daß die Verstärkereinrichtung mit veränderlichem Verstärkungsfaktor einen Regelverstärker (521) umfaßt, der mittels der zweiten Gleichkomponente gesteuert wird.

9. Konstantamplitudenwellen-Verstärker vom Kombinationstyp nach einem der Ansprüche 1 bis 5, **gekennzeichnet durch**
eine Verstärkereinrichtung mit veränderlichem Verstärkungsfaktor (448) zur Verstärkung von einer der ersten und zweiten Wellen mit konstanter Amplitude mit einem Verstärkungsfaktor und zur Ausgabe einer verstärkten Welle zu einem der ersten und zweiten Verstärker; und
eine weitere Steuereinrichtung (449) zur Erzeugung eines Korrekturwerts, der eine Verzerrungskomponente angibt, die in der Ausgangswelle enthalten ist, mittels Vergleich von einer der verstärkten Ausgaben mit einem vorbestimmten konstanten Wert (Vo) und zur Steuerung des Verstärkungsfaktors der Verstärkereinrichtung mit veränderlichem Verstärkungsfaktor, basierend auf dem Korrekturwert, so daß die Verzerrungskomponente, die in der Ausgangswelle enthalten ist, verringert wird.

## Revendications

1. Amplificateur du type à combinaison d'ondes d'amplitudes constantes, comportant:
un moyen (441, 502) de production d'une onde à fréquence variable, pour produire une première onde (A) d'amplitude constante, dont la fréquence peut être commandée par un signal de commande;
un premier moyen (442, 501) de combinaison d'ondes, couplé audit moyen de production d'une onde à fréquence variable, pour produire une deuxième onde (B) d'amplitude constante par combinaison d'une onde d'entrée (X) et de ladite première onde (A) d'amplitude constante;
un premier amplificateur (443, 503) amplifiant ladite première onde d'amplitude constante et produisant une première sortie amplifiée (kA);
un deuxième amplificateur (444, 504) amplifiant ladite deuxième onde d'amplitude constante et produisant une deuxième sortie amplifiée (kB);
un deuxième moyen (445, 507) de combinaison d'ondes couplé audit premier et audit deuxième amplificateurs, pour combiner ladite première et ladite deuxième sorties amplifiées et pour produire une onde de sortie (kX); et
un moyen de commande (446, 505; 511, 512; 524) couplé audit moyen de production d'une onde à fréquence variable et audit premier moyen de combinaison, et prévu pour calculer un terme (A² - B²) dans lequel A est une amplitude de ladite première onde d'amplitude constante reçue dudit moyen de production d'une onde à fréquence variable, et B est une amplitude de ladite deuxième onde d'amplitude constante reçue dudit premier moyen de combinaison, et pour délivrer un signal de sortie qui est fonction dudit terme calculé, en vue de produire ledit signal de commande.

2. Amplificateur de type à combinaison d'ondes d'amplitudes constantes selon la revendication 1, dans lequel un premier filtre (506) est prévu entre ledit moyen de commande et ledit moyen de production d'une onde à fréquence variable, lequel filtre extrait une composante en courant continu de ladite sortie dudit moyen de commande, pour délivrer ladite composante en courant continu audit moyen de production d'une onde à fréquence variable en tant que signal de commande.

3. Amplificateur du type à combinaison d'ondes d'amplitudes constantes selon la revendication 2, dans lequel ledit moyen de production d'une onde à fréquence variable comporte un oscillateur (502) commandé en tension, commandé par ladite composante en courant continu.

4. Amplificateur du type à combinaison d'ondes d'amplitudes constantes selon l'une quelconque des revendications 1 à 3, dans lequel ledit moyen de commande comporte un moyen opératoire (505) pour calculer ledit terme (A² - B²) et produire une sortie qui est une fonction dudit terme.

5. Amplificateur du type à combinaison d'ondes d'amplitudes constantes selon l'une quelconque des revendications 1 à 3, dans lequel ledit moyen de commande comporte:
un moyen opératoire (511) pour calculer des termes (A + B) et (A - B) à partir des amplitudes de ladite première et de ladite deuxième ondes d'amplitudes constantes, et
un moyen de multiplication (512) pour multiplier (A + B) et (A - B) de manière à obtenir le terme (A² - B²), et pour produire une sortie en fonction dudit terme.

6. Amplificateur du type à combinaison d'ondes d'amplitudes constantes selon l'une quelconque des revendications 1 à 5, comportant:
un moyen (521) amplificateur à gain variable pour amplifier l'une parmi ladite première et ladite deuxième ondes d'amplitudes constantes par un facteur de gain et pour délivrer une onde amplifiée à l'un parmi ledit premier et ledit deuxième amplificateurs; et
un moyen de commande supplémentaire (522) pour produire une valeur de correction indiquant la présence d'une composante de distorsion dans ladite onde de sortie, par comparaison de ladite onde d'entrée et de ladite onde de sortie, et pour commander le gain dudit moyen amplificateur à gain variable sur base de ladite valeur de correction, de telle sorte que ladite composante de distorsion présente dans ladite onde de sortie soit réduite.

7. Amplificateur de type à combinaison d'ondes d'amplitudes constantes selon la revendication 6, dans lequel un deuxième filtre (523) est prévu pour extraire une deuxième composante en courant continu de la sortie dudit moyen de commande supplémentaire (522), pour la fournir audit moyen amplificateur à gain variable.

8. Amplificateur de type à combinaison d'ondes d'amplitudes constantes selon la revendication 7, dans lequel ledit moyen amplificateur à gain variable comporte un amplificateur (521) à commande automatique du gain, commandé par ladite deuxième composante en courant continu.

9. Amplificateur de type à combinaison d'ondes d'amplitudes constantes selon l'une quelconque des revendications 1 à 5, comportant:
un moyen (448) amplificateur à gain variable pour amplifier l'une parmi ladite première et ladite deuxième ondes d'amplitudes constantes par un facteur de gain, et pour délivrer une onde amplifiée à l'un parmi ledit premier et ledit deuxième amplificateurs; et
un moyen de commande supplémentaire (449) pour produire une valeur de correction indicatrice de la présence d'une composante de distorsion dans ladite onde de sortie, par comparaison de l'une desdites sorties amplifiées à une valeur constante (Vo) prédéterminée, et pour commander ledit gain dudit moyen amplificateur à gain variable sur base de ladite valeur de correction, de telle sorte que ladite composante de distorsion contenue dans ladite onde de sortie soit réduite.
